Europäisches Patentamt

European Patent Office

Office européen des brevets

(11) Veröffentlichungsnummer: **0 333 018 B1**

(19)

(12) **EUROPÄISCHE PATENTSCHRIFT**

(45) Veröffentlichungstag der Patentschrift: **01.06.94**

(51) Int. Cl.⁵: **H01J 37/141**

(21) Anmeldenummer: **89104133.7**

(22) Anmeldetag: **08.03.89**

(54) **Objektivlinse zur Fokussierung geladener Teilchen.**

(30) Priorität: **17.03.88 DE 3809014**

(43) Veröffentlichungstag der Anmeldung:
**20.09.89 Patentblatt 89/38**

(45) Bekanntmachung des Hinweises auf die
Patenterteilung:
**01.06.94 Patentblatt 94/22**

(84) Benannte Vertragsstaaten:
**DE FR GB IT NL**

(56) Entgegenhaltungen:
**EP-A- 0 105 440**
**EP-A- 0 242 602**

(73) Patentinhaber: **ICT Integrated Circuit Testing**
**Gesellschaft für Halbleiterprüftechnik mbH**
**Klausnerring 1a**
**D-85551 Kirchheim(DE)**

(72) Erfinder: **Frosien, Jürgen, Dr.-Ing.**
**An der Ottosäule 18**
**D-8012 Ottobrunn(DE)**

(74) Vertreter: **Tetzner, Volkmar, Dr.-Ing. Dr. jur.**
**Van-Gogh-Strasse 3**
**D-81479 München (DE)**

# Beschreibung

Die Erfindung betrifft eine Objektivlinse zur Fokussierung geladener Teilchen mit einer elektrostatischen Immersionslinse, die eine erste und eine zweite Elektrode aufweist, die mit Potentialen derart beaufschlagt sind, daß die geladenen Teilchen im Feld der Immersionslinse von einer ersten auf eine wesentlich niedrigere zweite Energie abgebremst werden und ferner eine weitere Elektrode vorgesehen ist.

Aus der EP-A-0 242 602 ist ein Korpuskularstrahlgerät mit einer elektrostatisch-magnetischen Linse bekannt, deren Immersionslinse durch eine in Form eines Hohlzylinders ausgebildete erste Elektrode und eine im unteren Polschuh der Magnetlinse angeordnete zweite Elektrode gebildet wird. Koaxial um die erste Elektrode ist eine dritte äußere Elektrode vorgesehen, die bei geeigneter Spannungsbeaufschlagung eine kontinuierliche Veränderung der Brennweite der Linse ermöglicht.

In der EP-A-0 105 440 ist ein Spektrometerobjektiv mit einer Streufeldlinse und zwei zusätzlichen Elektroden beschrieben. Diese beiden Elektroden sind mit bestimmten Potentialen derart beaufschlagt, daß die an einer Probe ausgelösten Sekundärelektronen zunächst durch das Feld der ersten Elektrode beschleunigt und dann durch das Feld der zweiten Elektrode wieder abgebremst werden. Der durch die zweite Elektrode hindurchtretende Sekundärelektronenstrom stellt ein Maß für das zu messende Potential dar, auf dem sich die Probe befindet.

In allen Bereichen der Entwicklung und Fertigung mikro- und optoelektronischer Bauelemente besteht ein steigender Bedarf an hochauflösenden Rasterelektronenmikroskopen, um Submikrometerstrukturen visuell beurteilen, Abweichungen von Sollmustern festellen und topographische Daten wie Höhen, Breiten oder Neigungswinkel erfassen und auswerten zu können. Konventionelle Rasterelektronenmikroskope erreichen die geforderte Auflosung von wenigen Nanometern allerdings erst bei hohen Beschleunigungsspannen oberhalb etwa 20 kV, wo Resiststrukturen und integrierte Schaltungen geschädigt und nicht oder schlecht leitende Proben aufgeladen werden.

Der Erfindung liegt daher die Aufgabe zugrunde, eine Objektivlinse gemäß dem eingangs genannten Gattungsbegriff derart weiterzuentwickeln, daß eine aufladungsneutrale Untersuchung schlecht leitender Proben gewährleistet ist.

Diese Aufgabe wird erfindungsgemäß dadurch gelöst, daß eine weitere Elektrode im Strahlengang zwischen der Immersionslinse und der Probe angeordnet ist und zur Steuerung der Intensität des Stromes der von der Probe ausgehenden und in Richtung eines Detektors beschleunigten sekundären Teilchen ausgebildet ist.

Der mit der Erfindung erzielbare Vorteil besteht insbesondere darin, daß nicht oder schlecht leitende Proben mit hoher Auflösung und aufladungsneutral abgebildet oder vermessen werden können.

Weitere Ausgestaltungen der Erfindung sind Gegenstand der Unteransprüche und werden im folgenden anhand der Zeichnung näher beschrieben.

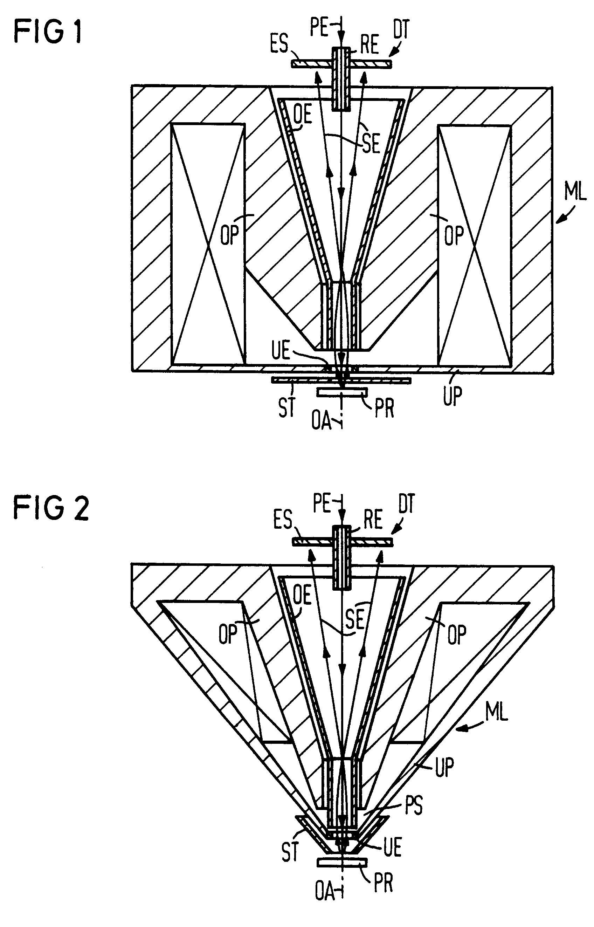

Hierbei zeigen die Fig. 1 bis 4 Ausführungsbeispiele erfindungsgemäßer Objektivlinsen für Rasterelektronenmikroskope.

Die in FIG 1 schematisch dargestellte Objektivlinse bildet die Komponente eines Rasterelektronenmikroskops, mit der man eine Elektronenquelle oder deren durch Kondensorlinsen verkleinertes Zwischenbild auf die Probe PR, insbesondere ein opto- oder mikroelektronisches Bauelement, abbildet. Die Objektivlinse besteht aus einer unsymmetrischen Magnetlinse ML, einer der Magnetlinse ML überlagerten elektrostatischen Immersionslinse OE/UE, einer auf einem einstellbaren Potential liegenden Steuerelektrode ST und einem Detektor DT zum Nachweis der von den Primärelektronen PE an der jeweiligen Meßstelle ausgelösten sekundären und rückgestreuten Elektronen SE. Die Immersionslinse umfaßt eine im Bereich des oberen Polschuhs OP der Magnetlinse ML isoliert angeordnete, kegelförmige Elektrode OE und eine in die Bohrung des unteren Polschuhes UP hineinragende Rohrelektrode UE, deren Potentiale $U_{OE}$ bzw. $U_{UE}$ so gewählt sind, daß sich innerhalb der Objektivlinse ein die Primärelektronen PE abbremsendes bzw. ein die Sekundärelektronen SE beschleunigendes elektrisches Feld aufbaut. So werden die mit einer hohen kinetischen Energie von beispielsweise $E_{PE}$ = 10 keV in die Linse eintretenden Primärelektronen PE bei einem Kathodenpotential von $U_K$ = - 1 kV und einem Anodenpotential von $U_A$ = + 9 kV auf die Endenergie von beispielsweise $E_{PE}$ = 1 keV abgebremst, wenn man die quellenseitige Elektrode OE der Immersionslinse auf das Anodenpotential $U_{OE}$ = $U_A$ = + 9 kV und die Elektrode UE auf Masse $U_{UE}$ = 0 V legt.

Aufgrund des dem fokussierenden Magnetfeld überlagerten elektrischen Verzögerungsfeldes besitzt die erfindungsgemäße Objektivlinse erheblich bessere Abbildungseigenschaften als die magnetische Linse ML ($U_{OE}$ = OV). So übertreffen die Farb- und Öffnungsfehlerkonstanten der magnetischen Linse ML die der elektrostatisch-magnetischen Objektivlinse um annähernd eine Größenordnung, wenn man die Primärelektronen PE im Feld der Immersionslinse um etwa einen Faktor 10 abbremst.

Der Detektor DT zum Nachweis der am jeweiligen Meßpunkt ausgelösten und im Feld der Immersionslinse beschleunigten sekundären und rückgestreuten Elektronen SE ist in dem gezeigten Ausführungsbeispiel unmittelbar oberhalb der Magnetlinse ML angeordnet. Er besteht aus einem ringförmigen elektronensensitiven Teil ES und einer in dessen Zentralbohrung isoliert gehalterten Hohlzylinder RE. Um die Primärelektronen PE gegenüber der üblicherweise am ringförmigen Teil ES anliegenden Hochspannung von beispielsweise $U_{ES}$ = 10 kV abzuschirmen, sollte der mit einem positiven Potential $U_{RE}$ von beispielsweise $U_{OE}$- 1 kV$\lesssim U_{RE}\lesssim$ $U_{OE}$ beaufschlagte Hohlzylinder RE bis in die obere Polschuhbohrung der Magnetlinse ML hineinreichen. Als Detektoren DT kommen insbesondere Halbleiterdetektoren, Channel-Plates oder Szintillator-Lichtleiter-Kombinationen in Betracht, die, im Unterschied zu FIG 1, auch innerhalb der Objektivlinse angeordnet sein können. Hierbei besitzen ringförmige Detektoren DT den Vorteil, daß sich nahezu alle der im Feld der Immersionslinse von der Probe PR abgesaugten Sekundärelektronen SE nachweisen lassen. Es können selbstverständlich auch Quadrantendetektoren verwendet werden.

In einem Rasterelektronenmikroskop ist eine aufladungsneutrale Vermessung und Abbildung isolierender Proben nur dann gewährleistet, wenn der jeweiligen Meßstelle keine Ladungen zugeführt oder entzogen werden. Man ist deshalb bestrebt die Bedingung

$$i_{PR} = i_{PE} - (i_{RE} + i_{SE}) : = 0$$

zumindest näherungsweise zu erfüllen. In dieser Gleichung bezeichnet $i_{PR}$ den Probenstrom, $i_{PE}$ den Primärelektronenstrom, $i_{RE}$ den Strom der rückgestreuten Elektronen und $i_{SE}$ den Sekundärelektronenstrom. Da der Sekundärelektronenstrom $i_{SE}$ gemäß der Gleichung

$$i_{SE} = \sigma (E_{PE}) \cdot i_{PE}$$

vom Primärelektronenstrom $i_{PE}$ und der von der Primärelektronenenergie $E_{PE}$ abhängigen Größe $\sigma$ ($\sigma$ wird üblicherweise als Ausbeute emittierter Elektronen bezeichnet) bestimmt wird, versucht man in konventionellen Rasterelektronenmikriskopen, die Ladungsbilanz durch eine Anpassung der Strahlenergie $E_{PE}$ (Änderung von $i_{SE} \sim \sigma$ ($E_{PE}$)) an die jeweiligen Gegebenheiten (Material der Meßstelle usw.) auszugleichen. Bei einem mit einer erfindungsgemäßen Objektivlinse ausgestatteten Rasterelektronenmikroskop ist eine solche Änderung der Strahlenergie $E_{PE}$ mit den damit verbundenen Nachteilen (Änderung der Beschleunigungsspannung, Nachfokussierung des Primärelektronenstrahls, Neueinstellung des Stigmatorfeldes) nicht notwendig, da man die Intensität des Sekundärelektronenstromes $i_{SE}$ mit Hilfe der unterhalb der Magnetlinse ML angeordneten Elektrode ST (Regelung der Stärke des auf die Sekundärelektronen SE wirkenden Absaugfeldes) in dem erforderlichen Maß abschwächen oder erhöhen kann. Das Potential $U_{ST}$ der die Absaugfeldstärke definierenden Ringelektrode bzw. Blende ST muß hierbei nur innerhalb eines Bereichs von etwa - 100 Volt $\lesssim U_{ST}$ $\lesssim$ 100 Volt einstellbar sein, wenn die Strahlenergie $E_{PE}$ annähernd der sogenannten Neutralpunktenergie $E_{NP}$ des jeweils abgetasteten Oberflächenbereichs entspricht. Da man die über die Gleichung $\sigma$ ($E_{NP}$) = 1 definierte Neutralpunktenergie $E_{NP}$ im allgemeinen nur näherungsweise kennt ($E_{NP}$ ist u. a. auch von der Topographie der Meßstelle abhängig) ist unter Umständen auch ein etwas größerer Einstellbereich des Potentials $U_{ST}$ erforderlich.

In Rasterelektronenmikroskopen mit konventionellen Objektivlinsen wird die Auflösung bei niedrigen Beschleunigungsspannungen unterhalb etwa 5 kV (die Neutralpunktenergien liegen mit wenigen Ausnahmen im Energiebereich zwischen etwa 0,5 und 4 keV) im wesentlichen durch den Boersch-Effekt und den Farbfehler der Objektivlinse begrenzt. So wächst infolge der Coulomb-Abstoßung der Elektronen deren räumlicher Abstand und damit unmittelbar der Strahldurchmesser auf der Probe (lateraler Boersch-Effekt). Außerdem führt die Elektron-Elektron-Wechselwirkung in Bereichen hoher Stromdichten, also insbesondere im Strahlerzeuger und in den Strahlüberkreuzungspunkten, zu einer Verbreiterung der Energieverteilung der Primärelektronen (energetischer Boersch-Effekt), was sich mittelbar über die chromatische Aberration der Objektivlinse ungünstig auf den Sondendurchmesser auswirkt. Der die Auflösung bestimmende Durchmesser d des Primärstrahls auf der Probe kann mit Hilfe der Gleichung

$$d^2 = d_o^2 + d_F^2$$

näherungsweise berechnet werden, in der $d_o$ den um die Coulomb-Abstoßung der Elektronen zwischen Strahlerzeuger und Probe vergrößerten geometrisch-optischen Strahldurchmesser und $d_F$ den Durchmesser des durch den Farbfehler der Objektivlinse erzeugten Fehlerscheibchens bezeichnet. Die Größe $d_F$ ist wiederum über die Gleichung

$$d_F = 2 C_F \cdot \alpha \cdot (e\Delta U)/(eU)$$

definiert, in der $C_F$ die Farbfehlerkonstante der Objektivlinse, $\alpha$ die Strahlappertur, eU die Strahlenergie (U = Beschleunigungsspannung, e = Elementarladung) und e $\Delta U$ die Breite der Energieverteilung der Primärelektronen bezeichnet. Zur Steigerung der Auflösung des Rasterelektronenmikroskops bei niedrigen Strahlenergien ist es daher erforderlich, den Einfluß des energetischen und des lateralen Boersch-Effektes weitgehend zu reduzieren. Da der Einfluß des lateralen Boersch-Effektes mit wachsender kinetischer Energie eU abnimmt, die Breite der Energieverteilung insbesondere im Strahlerzeuger dann aber deutlich zunimmt, sollten die Primärelektronen den Quellen cross-over mit einer niedrigen Energie von beispielsweise $E_{PE}$ = 2 keV durchlaufen (kleine relative Energiebreite $e\Delta U/eU$), um sie anschließend auf eine hohe Energie von beispielsweise $E_{PE}$ = 10 keV zu beschleunigen und erst unmittelbar oberhalb der Probe auf die gewünschte niedrige Endenergie von beispielsweise $E_{PE}$ = 0,5 - 2 keV abzubremsen. Als Einrichtung zur Abbremsung und Fokussierung der Primärelektronen kommt hierbei vorzugsweise die erfindungsgemäße Objektivlinse in Betracht, die die konventionelle Objektivlinse des Rasterelektronenmikroskops mit deren vergleichsweise großen Aberration ersetzt.

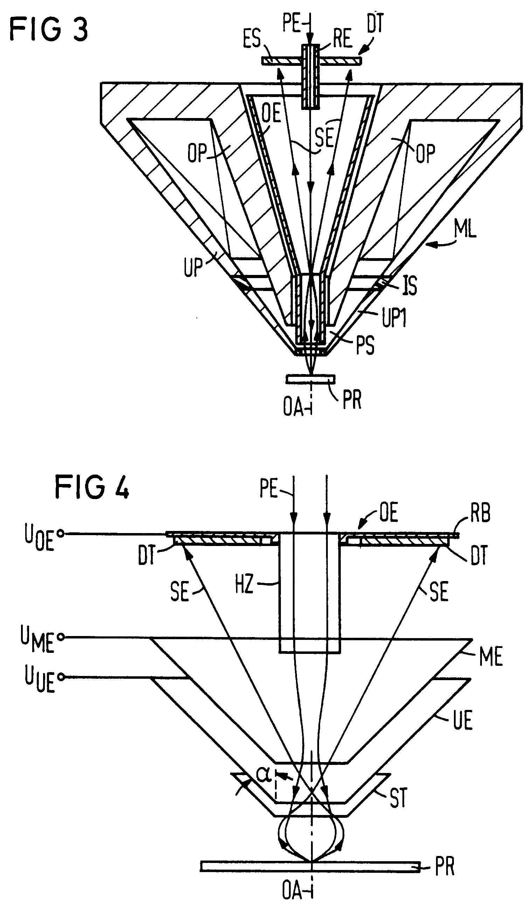

Um großflächige Proben in geneigtem Zustand bei kleinem Arbeitsabstand, d. h. bei kleiner Brennweite f abbilden und vermessen zu können, werden konventionelle Rasterelektronenmikroskope üblicherweise mit konischen Objektivlinsen ausgestattet. Aufgrund der Polschuhform besitzt dieser Linsentyp allerdings einen großen Polschuhspalt PS und damit eine vergleichsweise lange Brennweite f, was wiederum große Farb- und Öffnungsfehler bedingt ($C_F\sim f$). Eine wesentliche Reduktion der Aberrationen dieser Objektivlinse kann erfindungsgemäß dadurch erreicht werden, daß man der konischen Magnetlinse ML die aus FIG 1 bekannte Immersionslinse mit einer kegel- bzw. zylinderförmigen Elektrode OE und einer in der Bohrung des unteren Polschuhs UP angeordneten Rohrelektrode UE überlagert (siehe FIG 2). Die Verbesserung der Abbildungseigenschaften resultiert aus der mit der Abbremsung der Primärelektronen PE einhergehenden Verringerung der Farb- und Öffnungsfehlerkonstanten aber auch aus der Verschiebung der Hauptebene der Linse ML in Richtung der Probe PR (Verringerung der Brennweite f), was sich wiederum günstig auf die der Brennweite f proportionale Farbfehlerkonstante $C_F$ auswirkt. Die Elektrode ST zur Einstellung der Stärke des auf die Sekundärelektronen SE wirkenden Absaugfeldes ist in dem in FIG 2 dargestellten Ausführungsbeispiel ebenfalls unmittelbar unterhalb der Magnetlinse ML angeordnet und vorzugsweise kegelstumpfförmig ausgebildet. Wie die FIG 3 zeigt, kann die Elektrode ST auch in den unteren Polschuh UP der Magnetlinse ML integriert werden, indem man dessen durch einen Isolator IS vom oberen Polschuhteil getrennten unteren Teil UP1 mit dem gewünschten Potential $U_{ST}$ beaufschlagt.

Die FIG 4 zeigt eine elektrostatische Objektivlinse (Immersionslinse mit Mittelelektrode) deren quellenseitige Elektrode OE einen als Blende wirkenden ringförmigen Teil RB und einen sich in Richtung der Probe PR erstreckenden Hohlzylinder HZ aufweist. Die auf einem variablen positiven Potential $U_{ME}$ liegende Mittelelektrode ME, die probenseitige Elektrode UE sowie die Elektrode ST zur Steuerung der Intensität des von der Probe PR ausgehenden Sekundärelektronenstroms sind in dem Ausführungsbeispiel jeweils kegelstumpfförmig ausgebildet und konzentrisch zur Achse OA des Hohlzylinders HZ angeordnet. Um die üblicherweise auf Masse liegende Probe PR auch in geneigtem Zustand vermessen und abbilden zu können, sollten die Seitenflächen der kegelförmigen Elektroden ME, UE bzw. ST vorzugsweise einen Winkel $\alpha'$ zwischen etwa 30 und 70° mit der Achse OA einschließen. Der Detektor DT zum Nachweis der auf der Probe PR ausgelösten Sekundärelektronen SE ist innerhalb der Objektivlinse zwischen der quellenseitigen und der mittleren Elektrode OE bzw. ME angeordnet. Er besteht aus einem ringförmigen elektronensensitiven Teil, der vorzugsweise segmentiert aufgebaut ist. Da der Hohlzylinder HZ auf einem etwas niedrigeren Potential $U_{HZ}$ als die Mittelelektrode ME liegt ($U_{HZ}<U_{ME}$), werden auch die in Richtung der Strahlachse OA emittierten Sekundärelektronen SE zum Detektor DT abgelenkt und nachgewiesen. Auch diese Linse kann vorzugsweise in einem hochauflösenden Rasterelektronenmikroskop als Objektiv verwendet werden, um die auf hohe kinetische Energien beschleunigten Primäreleketronen PE auf die gewünschte Endenergie abzubremsen. Die Elektrode OE ist dann beispielsweise mit dem Potential der Anode des Strahlerzeugers beaufschlagt, während die Elektrode UE auf dem Potential der Probe PR, also üblicherweise auf Masse liegt. Das Potential $U_{ME}$ der mittleren Elektrode ME sollte dann in einem Bereich von etwa $U_{ME}$ = 1,1 $U_{OE}$ -2,5 $U_{OE}$ einstellbar sein.

Die Erfindung ist selbstverständlich nicht auf die beschriebenen Ausführungsbeispiele beschränkt. So ist es ohne weiteres möglich, die kegelförmige Elektrode OE durch eine Rohrelektrode zu ersetzen. Hierbei ist allerdings darauf zu achten, daß der Rohrdurchmesser größer als der maximale Querschnitt des innerhalb der Objektivlinse erzeugten divergierenden Sekundärelektronenbündels ist.

Anstelle der Elektrode UE kann auch der untere Polschuh als zweite Elektrode der Immersionslinse dienen.

Eine wesentliche Verbesserung der Auflösung eines Rasterelektronenmikroskops ist insbesondere dann zu erwarten, wenn man die Energie der Primärelektronen mit Hilfe der erfindungsgemäßen Objektivlinse um mindestens einen Faktor zwei verringert.

**Patentansprüche**

1. Objektivlinse zur Fokusssierung geladener Teilchen mit einer elektrostatischen Immersionslinse enthaltend eine erste und eine zweite Elektrode (OE bzw. UE), die mit Potentialen ($U_{OE}$, $U_{UE}$) derart beaufschlagt sind, daß die geladenen Teilchen (PE) im Feld der Immersionslinse von einer ersten auf eine wesentlich niedrigere zweite Energie abgebremst werden gekennzeichnet durch eine weitere Elektrode (ST), die im Strahlengang zwischen der Immersionslinse (OE/UE) und einer Probe (PR) angeordnet ist und
zur Steuerung der Intensität des Stromes der von der Probe (PR) ausgehenden und in Richtung eines Detektors (DP) beschleunigten sekundären Teilchen (SE) ausgebildet ist.

2. Objektivlinse nach Anspruch 1, **dadurch gekennzeichnet,** daß der Immersionslinse (OE/UE) eine magnetische Linse (ML) überlagert ist.

3. Objektivlinse nach Anspruch 2, **dadurch gekennzeichnet,** daß die weitere Elektrode (ST) in einer Bohrung des unteren Polschuhs (UP) der magnetischen Linse (ML) angeordnet ist.

4. Objektivlinse nach Anspruch 2, **dadurch gekennzeichnet,** daß die weitere Elektrode (ST) in den unteren Polschuhen (UP) der magnetischen Linse (ML) integriert ist.

5. Objektivlinse nach Anspruch 1, **gekennzeichnet durch** eine Immersionslinse mit Mittelelektrode (ME), wobei die Mittelelektrode (ME) und die zweite Elektrode (UE) der Immersionslinse kegelförmig ausgebildet sind und die kegelförmige dritte Elektrode (ST) unmittelbar unterhalb der zweiten Elektrode (UE) angeordnet ist.

6. Objektivlinse nach Anspruch 2, **dadurch gekennzeichnet,** daß die erste Elektrode (OE) in einer Bohrung des oberen Polschuhs (OP) der magnetischen Linse (ML) angeordnet ist und daß die zweite Elektrode (UE) in einer Bohrung des unteren Polschuhs (UP) angeordnet ist.

7. Objektivlinse nach Anspruch 6, **dadurch gekennzeichnet,** daß die zweite Elektrode (UE) durch den unteren Polschuh (UP) der magnetischen Linse (ML) gebildet wird.

**Claims**

1. Objective lens for focussing charged particles with an electrostatic immersion lens comprising a first and a second electrode (OE and UE respectively) which are supplied with potentials ($U_{OE}$, $U_{UE}$) so that the charged particles (PE) are decelerated in the field of the immersion lens from a first to a substantially lower second energy, characterised by a further electrode (ST) which is disposed in the beam path between the immersion lens (OE/UE) and a specimen (PR) and is constructed so as to control the intensity of the current of secondary particles (SE) emanating from the specimen (PR) and accelerated in the direction of a detector (DT).

2. Objective lens as claimed in Claim 1, characterised in that a magnetic lens (ML) is superimposed on the immersion lens (OE/UE).

3. Objective lens as claimed in Claim 2, characterised in that the further electrode (ST) is disposed in a bore of the lower pole piece (UP) of the magnetic lens (ML).

4. Objective lens as claimed in Claim 2, characterised in that the further electrode (ST) is integrated in the lower pole pieces (UP) of the magnetic lens (ML).

5. Objective lens as claimed in Claim 1, characterised by an immersion lens with a middle electrode (ME), wherein the middle electrode (ME) and the second electrode (UE) of the immersion lens are of conical construction and the conical third electrode (ST) is disposed immediately below the second electrode (UE).

6. Objective lens as claimed in Claim 2, characterised in that the first electrode (OE) is disposed in a bore of the upper pole piece (OP) of the magnetic lens (ML) and the second electrode (UE) is disposed in a bore of the lower pole piece (UP).

7. Objective lens as claimed in Claim 6, characterised in that the second electrode (UE) is formed by the lower pole piece (UP) of the magnetic lens (ML).

**Revendications**

1. Lentille d'objectif pour la focalisation de particules chargées, comprenant une lentille électrostatique à immersion comportant une première et une seconde électrode (OE ainsi que UE) qui sont mises à des potentiels tels ($U_{OE}$, $U_{UE}$) que les particules chargées (PE) soient freinées dans le champ de la lentille à immersion de manière qu'elles passent d'une première énergie à une seconde énergie notablement plus basse, caractérisée par une autre électrode (ST) qui est disposée dans la marche du faisceau entre la lentille à immersion (OE/UE) et un échantillon (PR) et qui est conçue pour la commande de l'intensité du courant des particules secondaires (SE) partant de l'échantillon (PR) et accélérées vers un détecteur (DP).

2. Lentille d'objectif selon la revendication 1, caractérisée en ce qu'une lentille magnétique (ML) est superposée a la lentille à immersion (OE/UE).

3. Lentille d'objectif selon la revendication 2, caractérisée en ce que l'autre électrode (ST) est disposée dans un trou de la pièce polaire inférieure (UP) de la lentille magnétique (ML).

4. Lentille d'objectif selon la revendication 2, caractérisée en ce que l'autre électrode (ST) est integrée dans les pièces polaires inférieures (UP) de la lentille magnétique (ML).

5. Lentille d'objectif selon la revendication 1, caractérisée par une lentille à immersion comprenant une électrode médiane (ME), l'électrode médiane (ME) et la seconde électrode (UE) de la lentille à immersion étant de forme conique et la troisième électrode conique (ST) étant disposée directement sous la seconde électrode (UE).

6. Lentille d'objectif selon la revendication 2, caractérisée en ce que la première électrode (OE) est disposée dans un trou de la pièce polaire supérieure (OP) de la lentille magnétique (ML) et en ce que la seconde électrode (UE) est disposée dans un trou de la pièce polaire inférieure (UP).

7. Lentille d'objectif selon la revendication 6, caractérisée en ce que la seconde électrode (UE) est formée de la pièce polaire inférieure (UP) de la lentille magnétique (ML).

**FIG 1**

**FIG 2**

FIG 3

FIG 4